(19) Europäisches Patentamt / European Patent Office / Office européen des brevets

(11) **EP 1 746 653 A1**

(12) **DEMANDE DE BREVET EUROPEEN**

(43) Date de publication:
**24.01.2007 Bulletin 2007/04**

(51) Int Cl.:
*H01L 23/544* *(2006.01)*     *C23C 16/24* *(2006.01)*
*C23C 16/44* *(2006.01)*     *G12B 21/20* *(2006.01)*

(21) Numéro de dépôt: **06117622.8**

(22) Date de dépôt: **21.07.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **22.07.2005 FR 0552284**

(71) Demandeur: **COMMISSARIAT A L'ENERGIE ATOMIQUE**
**75015 Paris (FR)**

(72) Inventeur: **Nolot, Emmanuel**
**38920, CROLLES (FR)**

(74) Mandataire: **Poulin, Gérard**
**Société BREVATOME**
**3, rue du Docteur Lancereaux**
**75008 Paris (FR)**

(54) **Procédé de réalisation d'étalons de bruit de fond diffus comportant de nano-structures sur une couche mince isolante**

(57) L'invention concerne un procédé de réalisation d'étalons de bruit de fond diffus comprenant respectivement une couche mince isolante (102,202) et une pluralité de nano-structures (114,116,214,216) sur la couche isolante, les étalons étant réalisés respectivement par :
- formation sur au moins une couche isolante (102,202) de germes (106,107) d'un premier matériau semi-conducteur par dépôt chimique à partir d'un premier gaz précurseur (104) du premier matériau semi-conducteur,
- formation sur la couche isolante (102,202) de nano-structures (114,116,214$_1$,214$_2$,214$_3$,214$_4$) à base d'un deuxième matériau semi-conducteur et sous formes de demi-sphères, à partir de germes stables du premier matériau semi-conducteur, par dépôt chimique à partir d'un deuxième gaz précurseur (110) du deuxième matériau semi-conducteur. L'invention concerne également un procédé d'étalonnage au moyen d'étalons obtenus à l'aide d'un tel procédé.

FIG. 3

**Description**

**DOMAINE TECHNIQUE**

L'invention concerne le domaine de la microélectronique et en particulier un procédé de réalisation d'étalons de bruit de fond diffus dotés respectivement d'une pluralité de nano-structures reposant sur une couche mince isolante. L'invention concerne également un procédé d'étalonnage, d'un appareil apte à mesurer et/ou exploiter une information de bruit de fond diffus, au moyen de tels étalons.

**ART ANTÉRIEUR**

Au cours du procédé de fabrication d'un dispositif microélectronique, tel qu'une puce ou un circuit intégré ou un MEMS (MEMS pour microelectromechanical system ou microsystème électromécanique), afin de garantir la qualité de ce dispositif, on effectue généralement une ou plusieurs étapes de contrôle de contamination particulaire ou/et de détection de défauts. Ces contrôles ou/et détections ont un caractère quasi-systématique et peuvent être mis en oeuvre à l'aide d'appareils aptes à effectuer un repérage et/ou un comptage optique par exemple à partir d'une image ou d'un signal d'un photomultiplicateur, de défauts sur une couche mince. Pour vérifier la qualité d'une couche mince, de tels appareils peuvent également effectuer des mesures de paramètres caractéristiques de la surface de cette couche mince tels que par exemple sa rugosité quadratique ou sa longueur de corrélation.

Pour effectuer l'analyse d'une couche mince, les appareils précités sont susceptibles de mettre en oeuvre un procédé consistant à :

- illuminer la couche mince par une ou plusieurs sources lumineuses,
- effectuer une mesure de la lumière diffusée et diffractée par cette couche mince, et exploiter une information obtenue à partir d'une composante basse fréquence du signal lumineux diffusé

ou diffracté, nommée « bruit de fond diffus » ou, selon la terminologie anglo-saxonne, « haze ».

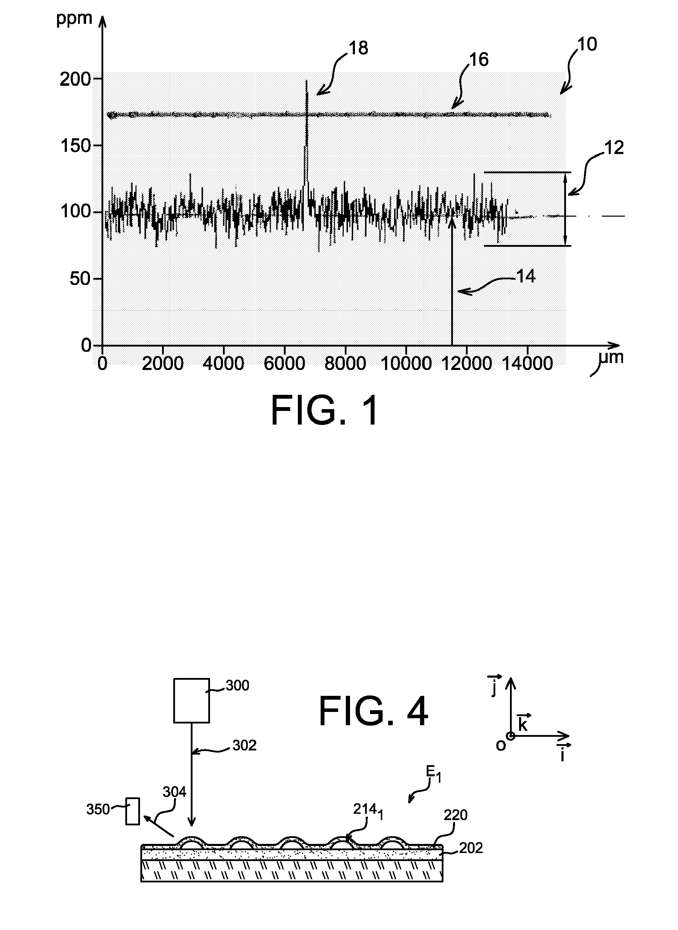

La figure 1 illustre un signal de mesure 10 effectué par un équipement de mesure de contamination particulaire, obtenu par exemple à l'aide du canal DWO (Dark Field Wide Channel Oblique Incidence ou « Incidence oblique de canal large en fond noir ») d'un équipement SP1$^{DLS}$ de la société KLA Tencor. Ce signal 10 comporte trois composantes :

- des pics d'intensité 18 supérieurs à un seuil de détection 16. Ces pics sont dus à la diffraction de la lumière laser incidente sur des défauts de la couche mince tel que des particules, des défauts cristallins, des rayures, etc.

- du bruit de mesure (variations quasi-aléatoires d'amplitude référencée 12),
- une composante basse fréquence 14, nommée bruit de fond diffus ou haze.

Les appareils exploitant l'information de bruit de fond diffus pourraient être étalonnés à l'aide d'un ou plusieurs étalons sous forme de plaques (« wafer » selon la terminologie anglo-saxonne) sur lesquelles des motifs de taille prédéterminée, destinés à reproduire ou imiter des défauts d'une couche mince, sont formés.

Le document US 5 198 869 présente un dispositif étalon de bruit de fond diffus, destiné à être employé notamment pour étalonner des scanners optiques de systèmes d'inspection de couches minces. Cet étalon comprend une plaque sur laquelle un réseau de motifs sous forme de puits répartis de manière quasi-aléatoire a été réalisé.

Le document US 5 599 464 présente quant à lui différents types d'étalons de bruit de fond diffus, réalisés par photo-lithographie, gravure ou attaque chimique. Ces étalons se présentent sous forme de plaques de silicium comportant des motifs de taille très faibles, par exemple de l'ordre de 10 Angstrom, en particulier sous formes de bosses ou de rainures, destinées à imiter les rugosités d'une plaque de silicium après polissage.

Les étalons précités ne permettent généralement d'atteindre des gammes de niveaux de bruit de fond diffus que peu étendues et par exemple inférieures à 0,1 ppm pour un canal DWO d'un équipement SP1$^{DLS}$. Il se pose le problème de trouver de nouveaux étalons de bruit de fond diffus, permettant de couvrir la totalité de la dynamique des équipements de mesure de contamination particulaire et de détection de défauts ainsi qu'un procédé de réalisation de tels étalons.

**EXPOSÉ DE L'INVENTION**

L'invention concerne un procédé de réalisation d'au moins un étalon de bruit de fond diffus doté d'au moins une couche mince isolante et d'une pluralité de nano-structures de formes de demi-sphères sur la couche mince isolante, comprenant les étapes de :

a) formation sur au moins une couche isolante de germes d'un premier matériau semi-conducteur par dépôt chimique à partir d'un premier gaz précurseur du premier matériau semi-conducteur,

b) formation sur la couche isolante des nano-structures à base d'un deuxième matériau semi-conducteur et à partir de germes stables du premier matériau semi-conducteur, par dépôt chimique à partir d'un deuxième gaz précurseur du deuxième matériau semi-conducteur.

Un tel procédé peut permettre d'obtenir des étalons dotés respectivement de nano-structures régulièrement réparties sur une couche isolante. Un tel procédé peut également permettre d'obtenir des étalons comportant respectivement des nano-structures de tailles identiques ou homogènes sur une couche isolante. Un tel procédé peut également permettre d'obtenir une gamme importante d'étalons différents en terme de taille des nano-structures que ces étalons comportent respectivement, et d'accéder à l'aide de cette gamme importante, à une gamme étendue de niveau de bruit de fond diffus accessible ou mesurable.

Selon une possibilité, l'étape a) peut être réalisée pendant une durée d'exposition au premier gaz précurseur, choisie en fonction d'une densité de germes prédéterminée, voulue sur la couche isolante.

La densité des nano-structures peut être comprise par exemple entre $10^{10}$ nano-structures/$cm^2$ et $5*10^{11}$ nano-structures/$cm^2$.

Selon un mode de réalisation, l'étape b) peut être réalisée pendant une durée d'exposition au deuxième gaz précurseur choisie en fonction d'une taille ou d'une gamme de taille des nano-structures prédéterminée, voulue.

Les nano-structures peuvent avoir une taille comprise entre 2 et 50 nanomètres.

Selon une variante, le deuxième précurseur peut être différent du premier précurseur.

Selon une mise en oeuvre particulière, le premier matériau semi-conducteur et le deuxième matériau semi-conducteur peuvent être identiques.

Le premier étalon et le deuxième étalon peuvent avoir été exposés au deuxième gaz lors de l'étape b) respectivement, pendant une première durée et pendant deuxième durée, la première durée ayant été choisie en fonction d'au moins une première valeur prédéterminée de bruit de fond diffus ou d'au moins une première gamme prédéterminée de valeurs de bruit de fond diffus que le premier étalon est destiné à mesurer, la deuxième durée ayant été choisie en fonction d'au moins une deuxième valeur prédéterminée de bruit de fond diffus ou d'au moins une deuxième gamme prédéterminée de valeurs de bruit de fond diffus que le deuxième étalon est destiné à mesurer.

L'invention concerne également un procédé de réalisation de plusieurs étalons de bruit de fond diffus comprenant : la réalisation d'au moins un premier étalon et d'au moins un deuxième étalon, le premier étalon et le deuxième étalon ayant des densités de nano-structures égales, le premier étalon comportant des nano-structures d'une première taille ou associées à une première gamme de taille, le deuxième étalon comportant des nano-structures d'une deuxième taille différente de la première taille ou associées à une deuxième gamme de tailles différente de la première gamme.

Le premier étalon et le deuxième étalon peuvent avoir été placés lors de l'étape a), en même temps et pendant une même durée dans un même réacteur ou dans une même chambre de dépôt, le premier étalon et le deuxième étalon ayant été formés à l'étape b) respectivement, par exposition au deuxième gaz précurseur pendant une première durée et par exposition au deuxième gaz précurseur pendant une deuxième durée, différente de la première durée.

L'invention concerne également un procédé d'étalonnage d'un appareil destiné à exploiter et/ou mesurer une valeur de bruit de fond diffus, au moyen d'étalons obtenus à l'aide d'un procédé de réalisation tel que décrit plus haut.

L'invention concerne également un procédé d'étalonnage d'un appareil destiné à exploiter et/ou mesurer une valeur de bruit de fond diffus comprenant les étapes consistant à :

- fournir au moins un étalon obtenu à l'aide du procédé de réalisation d'étalons tel que défini plus haut,
- émettre au moins un rayonnement lumineux en direction des nano-structures d'au moins étalon,
- mesurer, suite à l'émission, à partir d'au moins un rayon diffracté ou diffusé par l'étalon, au moins une valeur de bruit de fond diffus.

L'invention concerne également un dispositif étalon de bruit de fond diffus comportant : au moins une couche mince isolante, une pluralité de nano-structures ayant une forme de demi-sphère ou de bosse, régulièrement réparties sur la couche isolante.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un signal de mesure de bruit de fond diffus ;
- les figures 2A-2E, illustrent différentes étapes d'un procédé, suivant l'invention, de réalisation d'un dispositif microélectronique étalon de bruit de fond diffus ;
- la figure 3 illustre un ensemble de plusieurs étalons de bruit de fond diffus comportant des nano-structures régulièrement réparties sur une couche isolante, les nano-stuctures ayant des tailles différentes d'un étalon à un autre étalon et des tailles identiques ou sensiblement identiques au sein d'un même étalon ;
- la figure 4 illustre un procédé d'étalonnage à l'aide d'un étalon mis en oeuvre suivant l'invention, comportant des nano-structures régulièrement réparties sur une couche isolante ;
- la figure 5A, illustre une relation, pour des étalons de bruit de fond diffus formés à l'aide d'un procédé suivant l'invention, entre une durée qu'a eu la deuxième étape de dépôt ou phase de croissance respectivement pour ces étalons, et un niveau de bruit de fond diffus mesurable ou accessible respectivement à l'aide de ces étalons ;
- la figure 5B, illustre une relation, pour des étalons de bruit de fond diffus formés à l'aide d'un procédé suivant l'invention, entre une durée qu'a eu la deuxième étape de dépôt ou phase de croissance respectivement pour ces étalons, et un niveau rugosité quadratique mesurable ou accessible à l'aide respectivement de ces étalons.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

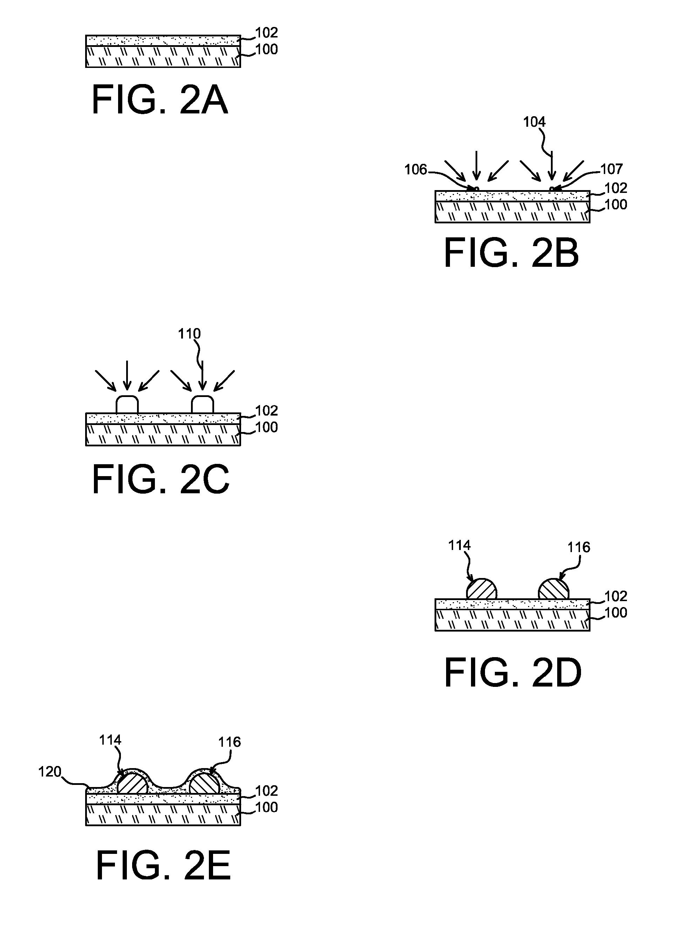

Un exemple de procédé de réalisation d'un étalon de bruit de fond diffus suivant l'invention, va à présent être décrit en liaison avec les figures 2A-2E.

Le matériau de départ du procédé peut être un support recouvert d'une couche mince isolante, par exemple une couche de diélectrique tunnel. Ce matériau de départ peut être formé à partir d'un substrat 100, qui peut être semi-conducteur, par exemple à base de silicium, et sur lequel on fait croître une épaisseur d'oxyde thermique par exemple comprise entre 1 et 10 nanomètres d'épaisseur, par exemple de l'ordre de 7 nanomètres d'épaisseur, afin de former la fine couche isolante 102 (Figure 2A). Le substrat 100 peut être par exemple du silicium <100> de résistivité comprise entre 7 et 10 $\Omega$.m et dopé P.

Une étape de vérification de la rugosité du substrat 100 et/ou de la fine couche isolante 102 peut être éventuellement prévue. Cette vérification peut être mise en oeuvre à l'aide d'une mesure AFM (AFM pour « Atomic Force Microscopy » ou microscopie à force atomique). Le substrat 100 a de préférence une rugosité quadratique inférieure à 0,5 nanomètre. La fine couche isolante 102 a de préférence une rugosité quadratique inférieure à 0,5 nanomètre. Ensuite, une étape de nettoyage de la couche 102 pour éliminer ou/et empêcher la formation de contaminants organiques peut être effectuée. Cette étape peut être réalisée par exemple, à l'aide d'un nettoyage chimique au moyen d'un bain d'ozone aqueux suivi d'un rinçage à l'eau desionisée, ou par passage au four à une température par exemple de l'ordre 230 °C pendant une durée par exemple de l'ordre de 4 minutes.

Puis, on forme, en deux temps, ou en deux étapes distinctes, une pluralité de nano-structures sur la couche isolante 102.

Par « nano-structures » on entend des éléments de taille inférieure à 50 nanomètres, par exemple de taille comprise entre 2 et 50 nanomètres. Les nano-structures peuvent avoir des formes de bosses ou de demi-sphères. Par « taille » des nano-structures, on entend le diamètre de la base desdites demi-sphères. Les nano-structures peuvent être formées par exemple à base d'au moins un matériau semi-conducteur. Les nano-structures peuvent être par exemple des éléments cristallins, et seront dans ce cas, appelés nano-cristaux.

Le support ou substrat 100 recouvert de la fine couche isolante 102 peut être tout d'abord placé dans un réacteur LPCVD (LPCVD pour « Low Pressure Chemical Vapor Déposition » ou « dépôt chimique en phase vapeur sous pression réduite »).

On effectue, dans un premier temps, une première étape de dépôt chimique ou de CVD, que l'on appellera également « phase de nucléation ». A l'issue de cette phase de nucléation, on forme des germes stables d'un premier matériau semi-conducteur sous forme d'îlots reposant sur la couche isolante 102, et régulièrement répartis sur cette couche 102. Par germes « stables » on entend des germes qui ne sont pas en train de croître ou dont la croissance est stoppée.

Pendant cette première étape, on envoie à l'intérieur du réacteur, sur le substrat 100 recouvert de la couche diélectrique 102, un premier gaz précurseur 104, qui va permettre la formation de germes 106, 107, sur la couche isolante 102. Les germes 106, 107, peuvent être à base d'un premier matériau semi-conducteur. Par « germes » on désigne des amas de quelques dizaines à quelques milliers d'atomes. Ces amas ont une taille très faible par rapport à celle des nano-structures finales que l'on souhaite obtenir. Le premier précurseur 104 est choisi de sorte que le matériau de la couche isolante 102 accepte la formation desdits germes 106, 107. Le premier précurseur 104 peut être par exemple du silane pour permettre de former des germes 106, 107, à base de silicium (figure 2B). Le premier précurseur 104 peut être éventuellement dilué dans un gaz vecteur.

Préférentiellement, le matériau diélectrique de la couche 102 est choisi de manière à ce qu'il soit le plus réactif possible avec le premier précurseur 104 du premier matériau semi-conducteur, ceci afin de favoriser la formation des germes plutôt que la diffusion du précurseur à la surface du matériau diélectrique de la couche 102. Le matériau diélectrique peut être par exemple du $SiO_2$. L'exposition de la couche diélectrique 102 au premier gaz précurseur 104 est réalisée à une température suffisante pour que le précurseur du silicium puisse se dissocier et engendrer la formation des germes cristallins 106, 107. La température du dépôt peut également être choisie la plus basse possible afin de limiter la vitesse de croissance des germes. Par exemple, dans le cas du silane comme précurseur du silicium, la formation des germes de silicium peut être faite à une température comprise entre 550°C et 650°C. La pression partielle du précurseur du silicium peut être choisie faible pour que la vitesse de croissance des germes 106, 107, soit lente. Dans le cas du silane comme précurseur du silicium, la pression partielle de silane peut être comprise entre 35 mTorr et 200 mTorr, par exemple entre 40 mTorr et 80 mTorr.

Le temps de dépôt peut être choisi en fonction d'une densité de germes souhaitée pour le dispositif microélectronique étalon. Une croissance lente des germes 106, 107, peut être mise en oeuvre afin d'obtenir un contrôle amélioré de la taille des germes. Le temps d'exposition de la couche 102 au premier gaz précurseur peut être compris par exemple entre 40 secondes et 200 secondes. Le temps d'exposition au premier gaz précurseur peut être court par exemple compris entre 40 secondes et 80 secondes, de manière à obtenir une densité faible surfacique de germes.

La densité des germes peut être également contrôlée par les propriétés chimiques de surface de la couche d'oxyde 102. La densité des germes formés pendant la première étape détermine la densité finale de nano-structures. Ainsi, lors de la première étape, on ajuste la densité spatiale finale de nano-structures que l'on souhaite obtenir sur la couche 102. Les conditions du premier dépôt peuvent être ajustées de manière à obtenir une densité surfacique de germes sur la couche 102 comprise entre $10^{10}$ germes/cm$^2$ et $5*10^{11}$ germes/cm$^2$, par exemple de l'ordre de $5*10^{10}$ germes/cm$^2$. L'étape de formation de germes stables d'un premier matériau semi-conducteur est réalisée pendant une durée ou un temps d'exposition choisi en fonction de la densité de germes souhaitée, de sorte que plus le temps d'exposition de la couche 102 au premier précurseur 104 est long, plus la densité de germes 106, 107 est élevée.

A la fin de la première étape, on obtient des germes stables sur la couche isolante 102, répartis de manière régulière, et selon une densité choisie.

Puis lors d'une deuxième étape distincte de la première étape, et que l'on appellera « phase de croissance », on expose les germes 106, 107, à un deuxième gaz précurseur 110. Des nano-structures à base d'un deuxième matériau semi-conducteur vont croître sélectivement sur les germes 106, 107 formés pendant la première étape (figure 2C). Le premier matériau semi-conducteur et le deuxième semi-conducteur peuvent être identiques et par exemple à base de silicium.

Le deuxième précurseur 110 est choisi pour engendrer un dépôt sélectif du deuxième matériau semi-conducteur uniquement sur lesdits germes 106, 107. Le deuxième gaz précurseur 110 est de préférence différent du premier gaz précurseur 104. Le fait d'utiliser deux gaz précurseurs 104 et 110 différents pour la première étape et pour la deuxième étape, peut permettre d'une part de maîtriser la densité des nano-structures et d'autre part, d'obtenir des nano-structures de taille uniforme. Le deuxième gaz précurseur 110 peut être par exemple du dichlorosilane ou $Si_2H_2Cl_2$, notamment dans un cas où l'on souhaite former des nano-structures à base de silicium.

Le temps de dépôt lors de la seconde étape est choisi en fonction de la taille des nano-structures que l'on souhaite obtenir. Lors de la deuxième étape, on peut contrôler la taille des nano-structures par les conditions de dépôt, notamment la pression, la température et la durée de cette deuxième étape de dépôt. On se place préférentiellement dans des conditions de procédé telles que la vitesse de croissance des nano-structures est faible, par exemple inférieure à 1,2 nanomètres/min, ceci afin de pouvoir contrôler avec une meilleure précision la taille desdites nano-structures. On se placera donc à une faible pression partielle du deuxième précurseur du premier matériau et à une température de dépôt basse mais permettant sa dissociation à la surface de la couche diélectrique 102. La température du second dépôt peut être comprise entre 550°C et 670°C, par exemple entre 630°C et 670°C. La pression partielle du deuxième précurseur peut être par exemple comprise entre 35 mTorr et 200 mTorr, ou par exemple entre 40 mTorr et 80 mTorr.

La durée de la seconde étape peut être par exemple comprise entre 150 et 2000 secondes. A l'aide de ce procédé en deux étapes distinctes, on obtient un étalon comportant un support 100, ainsi qu'une couche diélectrique 102 présentant en surface des nano-structures 114, 116, de tailles identiques ou sensiblement identiques ou homogènes sur la couche diélectrique 102, et réparties de manière uniforme ou sensiblement uniforme (figure 2D). Du fait de la séparation des étapes de nucléation et de croissance du procédé en deux étapes de dépôt décrit ci-dessus :

- la distribution des nano-structures 114, 116, obtenues par ce procédé est très régulière sur la couche isolante 102 ;
- la dispersion en taille des nano-structures 114, 116, peut être faible, par exemple inférieure à 30%. En utilisant un premier précurseur à base de silane dans la première étape et un deuxième précurseur à base de dichlorosilane dans la deuxième étape, cette dispersion en taille peut être inférieure à 20 %.

La densité de nano-structures 114, 116, de l'étalon peut être comprise par exemple entre $10^{10}$ nano-structures/cm$^2$ et $5*10^{11}$ nano-structures/cm$^2$, par exemple de l'ordre de $5*10^{10}$ nano-structures/cm$^2$. Les nano-structures 114, 116, de l'étalon peuvent avoir une taille comprise par exemple entre 2 et 30 nanomètres.

Une couche d'encapsulation 120 des nano-structures 114, 116, peut être également formée (figure 2E). La couche d'encapsulation 120 est de préférence formée à base d'un matériau transparent ou faiblement absorbant vis-à-vis de rayons lumineux. La couche d'encapsulation 120 est de préférence réalisée de manière à recouvrir entièrement les nano-structures 114, 116. La couche d'encapsulation 120 peut avoir une épaisseur comprise par exemple entre 3 et 50 nanomètres et être à base d'un matériau diélectrique tel que par exemple du $SiO_2$ ou du $Si_3N_4$. La couche d'encapsulation 120 peut avoir un rôle de protection, et permettre de préserver les nano-structures 114 et 116 d'usure ou d'altérations. L'épaisseur de la couche d'encapsulation 120 et le ou les matériau(x) à partir duquel ou desquels cette couche 120 est formée, peuvent être choisis de manière à ce que cette couche 120 ait une faible contribution dans les mesures de haze, et/ou puisse être nettoyée aisément. La couche d'encapsulation 120 peut permette de stabiliser la rugosité formée par des nano-structures enterrées.

Un contrôle de la densité surfacique effective des nano-structures 114 et 116 par microscopie électronique à balayage peut permettre d'affiner les paramètres procédés de la première étape de dépôt. De même, un contrôle par microscopie électronique à balayage et/ou par microscopie électronique en transmission de la taille des nano cristaux permettra d'optimiser la durée de la seconde étape de dépôt.

On peut, à l'aide d'un procédé tel que décrit précédemment, obtenir une gamme importante d'étalons différents. Ce procédé peut permettre d'obtenir un jeu ou un ensemble de plusieurs étalons comportant des densités respectives de nano-structures identiques et des tailles de nano-structures homogènes au sein de chaque étalon, et distinctes entre lesdits étalons.

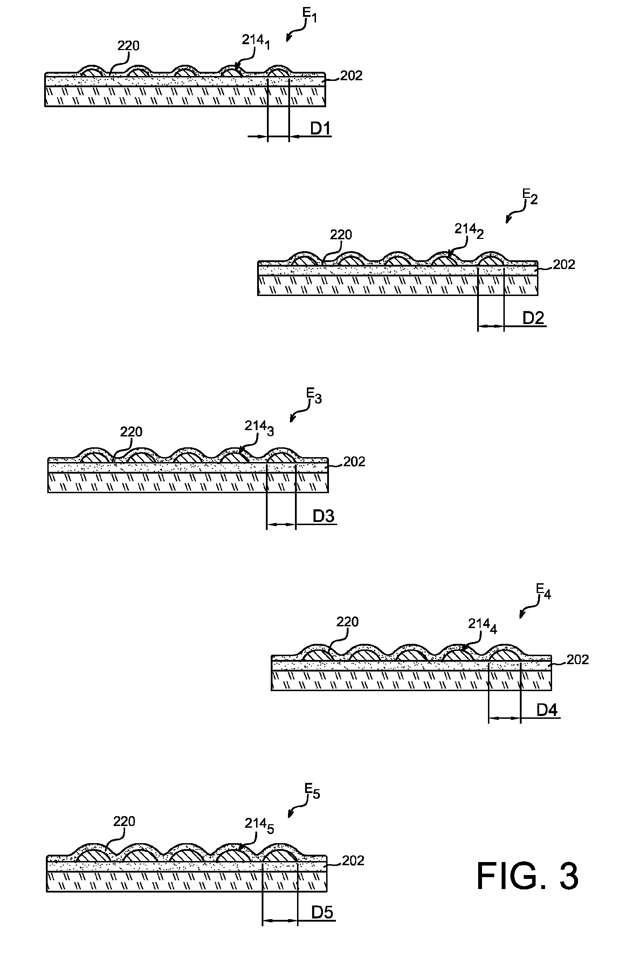

Un ensemble ou un jeu de plusieurs étalons E1, E2, E3, E4, E5 de bruit de fond diffus, mis en oeuvre à l'aide d'un procédé tel que décrit précédemment, est illustré sur la figure 3. Ces étalons E1, E2, E3, E4, E5 sont formés sur des supports différents et comportent respectivement des nano-structures $214_1$, $214_2$, $214_3$, $214_4$, $214_5$ de la forme de demi-sphères, reposant respectivement sur une première couche mince isolante 202 et enrobées ou encapsulées respectivement par une deuxième mince couche isolante 220. Les étalons E1, E2, E3, E4, E5 ont entre eux des densités respectives de nano-structures identiques ou sensiblement identiques, et par exemple comprises entre $1*10^{10}$ nano-structures/cm$^2$ et $5*10^{11}$ nano-structures/cm$^2$, par exemple de l'ordre de $5*10^{10}$ nano-structures/cm$^2$. Pour former les étalons E1, E2, E3, E4, E5 comportant des densités respectives de nano-structures $214_1$, $214_2$, $214_3$, $214_4$, $214_5$ identiques, les conditions de dépôt de la phase de nucléation, et en particulier la durée de la phase de nucléation, peuvent avoir été choisis identiques pour tous les étalons E1, E2, E3, E4, E5. Selon une possibilité, pour obtenir des densités respectives identiques de nano-structures entre les étalons E1, E2, E3, E4, E5, ces derniers peuvent avoir été avantageusement formées lors d'une même phase de nucléation, dans un même réacteur ou dans une même chambre de déposition pendant une même durée d'exposition au premier gaz précurseur.

Dans le jeu d'étalons, un premier étalon E1 comporte une première pluralité de nano-structures $214_1$, d'une première taille D1 ou associées à une première gamme de tailles.

Un deuxième étalon E2 comporte une deuxième pluralité de nano-structures $214_2$, d'une deuxième taille D2 différente de la première taille D1 ou associées à une deuxième gamme de tailles différente de la première gamme.

Un troisième étalon E3 comporte une troisième pluralité de nano-structures $214_3$, d'une troisième taille D3 différente de D1 et de D2, ou associées à une troisième gamme de tailles, différente de la première gamme et de la deuxième gamme.

Un quatrième étalon E4 comporte une quatrième pluralité de nano-structures $214_4$, d'une quatrième taille D4 différente de D1 et de D2 et de D3, ou associées à une quatrième gamme de tailles différente de la première et de la deuxième gamme et de la troisième gamme.

Un cinquième étalon E5 comporte une quatrième pluralité de nano-structures $214_5$, d'une cinquième taille D5 différente de D1 et de D2 et de D3 et de D4 ou associées à une cinquième gamme de tailles différente de la première et de la deuxième et de la troisième et de la quatrième gammes autour de la cinquième taille D5.

Selon une possibilité, pour obtenir des tailles différentes de nano-structures entre les étalons E1, E2, E3, E4, E5, lors de la phase de croissance, le premier étalon, le deuxième étalon, le troisième étalon, le quatrième étalon, le cinquième étalon, peuvent avoir été formées séparément et/ou avec des durées respectives différentes d'exposition au deuxième gaz précurseur.

Un tel jeu d'étalons E1, E2, E3, E4, E5 peut être utilisé lors d'un procédé d'étalonnage d'un appareil apte à mesurer du bruit de fond de fond diffus et à exploiter une information de bruit de fond diffus mesurée. De par l'étendue de la gamme de tailles de nano-structures qu'il comporte, un tel jeu d'étalons peut permettre d'étalonner ledit appareil sur une large dynamique ou une large gamme de bruit de fond diffus, par exemple entre 0,03 et 300 ppm pour un canal DWO d'un équipement SP1$^{DLS}$.

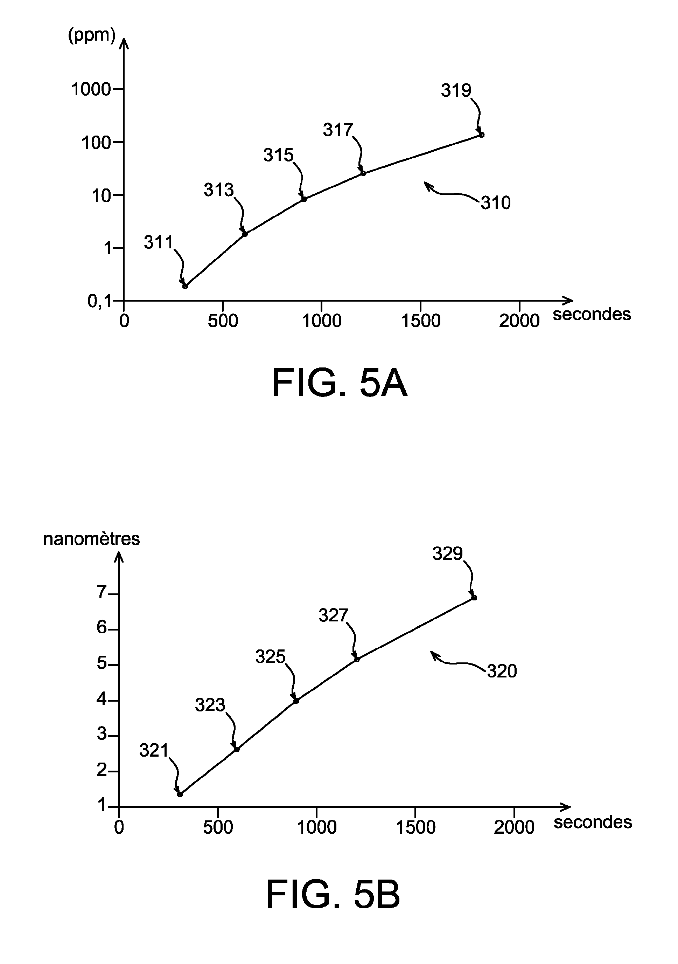

La figure 4 illustre un procédé d'étalonnage d'un appareil apte à mesurer et à exploiter au moins une information ou au moins une valeur de bruit de fond diffus, à l'aide d'un jeu d'étalons tel que décrit précédemment en liaison avec la figure 2.

Au cours de ce procédé, un premier étalon E1 est placé sous un faisceau de rayons lumineux 302 émis par une source 300, par exemple une source laser. Les dimensions relatives du faisceau incident et des nano-structures sont telles que plusieurs nano-structures de l'étalon E1 sont illuminées par le faisceau 302. L'étalon peut être mis en rotation sur lui-même par exemple à une vitesse de 4000 tours/min. Le faisceau illuminant l'étalon E1 peut quant à lui effectuer un mouvement suivant une trajectoire de spirale.

Le faisceau 302 peut réaliser un angle non-nul, par exemple compris entre 0° et 85°, avec une normale au plan principal (le plan principal de la couche isolante 202 étant défini par une direction parallèle à un vecteur à $[0 ; \vec{i} ; \vec{k}]$ d'un repère orthogonal $[0 ; \vec{i} ; \vec{j} ; \vec{k}]$ sur la figure 3) de la couche isolante 202 sur laquelle sont disposées les nano-structures $214_1$. Un ou plusieurs rayons lumineux diffusés ou diffractés 304 par les nano-structures $214_1$ sont recueillis par au moins un détecteur 350. Du signal lumineux reçu par le détecteur 350, on extrait une composante basse fréquence correspondant à une mesure de bruit de fond diffus ou « haze », comme cela est décrit dans le document « Monitoring and qualification using comprehensive surface haze information », Holsteyns et al., IEEE International Symposium on Semiconductor Manufacturing, 2003, p 378-381. Le résultat de cette mesure est ensuite utilisé comme une première valeur de référence.

On peut ensuite effectuer une pluralité de mesures en différents endroits ou sur différentes zones de l'échantillon. La dispersion de cette pluralité de mesures de bruit de fond diffus peut être inférieure ou égale à 30 %.

On peut ensuite réitérer le procédé, à l'aide du deuxième étalon E2, du troisième étalon E3, du quatrième étalon E4, du cinquième étalon E5, afin d'obtenir une deuxième, une troisième, une quatrième puis une cinquième valeur de référence.

De telles mesures peuvent être utilisées pour effectuer le calibrage, suivre les dérives, comparer les performances de mesures, d'appareils exploitant des informations de bruit de fond diffus et/ou de rugosité, tels que les appareils de mesure de rugosité de couches minces, de détection de défauts réalisés sur des couches minces, les compteurs de particules, les microscopes à force atomique, les profilomètres mécaniques. De telles mesures peuvent être utilisés pour effectuer le calibrage, suivre les dérives, comparer les performances de mesures, d'équipements de détection de défauts tels que décrits dans le document US 6 201 601 et US 6 271 916 ou par exemple d'équipements SP1$^{DLS}$ fabriqués par la société KLA Tencor.

Sur la figure 5A, la courbe 310 est représentative d'un niveau de bruit de fond diffus en fonction de la durée de la deuxième étape du procédé de fabrication d'étalons.

Cette courbe 310 illustre en particulier une dépendance ou une relation pour chaque étalon de bruit de fond diffus, entre la durée qu'a eu la deuxième étape ou la phase de croissance pour cet étalon, et une valeur de bruit de fond mesurable ou accessible, à l'aide de cet étalon. Des points 311, 313, 315, 317, 319, de cette courbe 310 représentent respectivement : une valeur de bruit de fond diffus mesurable ou accessible par mesure à l'aide du premier étalon E1, une valeur de bruit de fond diffus mesurable ou accessible par mesure à l'aide du deuxième étalon E2, une valeur de bruit de fond diffus mesurable ou accessible par mesure à l'aide du troisième étalon E3, une valeur de bruit de fond diffus mesurable ou accessible par mesure à l'aide du quatrième étalon E4, une valeur de bruit de fond diffus mesurable ou accessible par mesure à l'aide du cinquième étalon E5.

Lors de la fabrication d'un échantillon donné parmi les échantillons E1, E2, E3, E4, E5, la durée de la deuxième étape peut avoir été choisie en fonction d'une valeur de bruit de fond diffus ou d'une gamme de valeurs de bruit de fond diffus prédéterminée que cet échantillon est destiné à mesurer. La durée de la deuxième étape peut avoir été choisie en fonction d'une valeur de bruit de fond diffus ou d'une gamme de valeurs de bruit de fond diffus prédéterminée à laquelle on souhaite accéder par mesure à l'aide de cet échantillon donné.

Sur la figure 5B, la courbe 320 est représentative d'une valeur de rugosité quadratique en fonction de la durée de la deuxième étape ou de la phase de croissance. Cette courbe 320 illustre une dépendance ou une relation pour chaque étalon de bruit de fond diffus entre la durée qu'a eu la deuxième étape de dépôt ou phase de croissance pour cet étalon, et une valeur de rugosité quadratique mesurable ou accessible par cet étalon. Des points 321, 323, 325, 327, 329, de cette courbe 320 représentent respectivement : une valeur de rugosité quadratique mesurable ou accessible à l'aide du premier étalon E1, une valeur rugosité quadratique mesurable ou accessible à l'aide du le deuxième étalon E2, une valeur de rugosité quadratique mesurable ou accessible à l'aide du troisième étalon E3, une valeur de rugosité quadratique mesurable ou accessible à l'aide du quatrième étalon E4, une valeur de rugosité quadratique mesurable ou accessible à l'aide du cinquième étalon E5.

Lors de la fabrication d'un échantillon donné parmi les échantillons E1, E2, E3, E4, E5, la durée de la deuxième étape peut avoir été choisie en fonction d'une valeur de bruit de fond diffus ou d'une gamme de valeurs de rugosité quadratique prédéterminée que cet échantillon est destiné à mesurer.

Les valeurs de bruit de fond diffus des courbes 310 et 320 peuvent avoir été obtenues à l'aide d'un équipement de détection de défauts, par exemple à l'aide d'un appareil SP1 de la société KLA Tencor, et en particulier à l'aide du canal DWO (Dark Field Wide Channel Oblique Incidence ou « Incidence oblique de canal large en fond noir »).

## Revendications

**1.** Dispositif étalon de bruit de fond diffus comportant :
au moins une couche mince isolante, une pluralité de nano-structures ayant respectivement une forme de demi-sphère ou de bosse, les nano-structures étant régulièrement réparties sur la couche isolante.

**2.** Procédé de réalisation d'au moins un étalon de bruit de fond diffus comportant une couche isolante et une pluralité de nano-structures ayant respectivement une forme de demi-sphère ou de bosse et étant régulièrement réparties sur la couche isolante, comprenant les étapes de :

a) formation sur au moins une couche isolante (102,202) de germes (106,107) d'un premier matériau semi-conducteur par dépôt chimique à partir d'un premier gaz précurseur (104) du premier matériau semi-conducteur,
b) formation sur la couche isolante (102,202) de nano-structures (114, 116, 214$_1$, 214$_2$, 214$_3$,

214$_4$) à base d'un deuxième matériau semi-conducteur et à partir de germes stables du premier matériau semi-conducteur, par dépôt chimique à partir d'un deuxième gaz précurseur (110) du deuxième matériau semi-conducteur.

**3.** Procédé selon la revendication 2, dans lequel l'étape a) est réalisée pendant une durée d'exposition au premier gaz précurseur choisie en fonction d'une densité de germes prédéterminée, voulue sur la couche isolante (102,202).

**4.** Procédé selon l'une des revendications 2 ou 3, dans lequel l'étape b) est réalisée pendant une durée d'exposition au deuxième gaz précurseur choisie en fonction d'une taille ou d'une gamme de tailles des nano-structures prédéterminée, voulue.

**5.** Procédé selon l'une des revendications 2 à 4, le deuxième précurseur étant différent du premier précurseur.

**6.** Procédé selon l'une des revendications 2 à 5, le premier matériau semi-conducteur et le deuxième matériau semi-conducteur étant identiques.

**7.** Procédé selon l'une des revendications 2 à 6, les nano-structures ayant une taille comprise entre 2 et 50 nanomètres.

**8.** Procédé de réalisation de plusieurs étalons de bruit de fond diffus comprenant : la réalisation d'au moins un premier étalon et d'au moins un deuxième étalon, respectivement par un procédé selon l'une des revendications 1 à 6, le premier étalon et le deuxième étalon ayant des densités de nano-structures égales, le premier étalon comportant des nano-structures d'une première taille ou associées à une première gamme de tailles, le deuxième étalon comportant des nano-structures d'une deuxième taille différente de ladite première taille, ou associées à une deuxième gamme de tailles différente de ladite première gamme.

**9.** Procédé selon la revendication 8, le premier étalon et le deuxième étalon ayant été placés lors de l'étape a), en même temps et pendant une même durée dans un même réacteur ou dans une même chambre de dépôt, le premier étalon et le deuxième étalon ayant été formés à l'étape b) respectivement, par exposition au deuxième gaz précurseur pendant une première durée et par exposition au deuxième gaz précurseur pendant une deuxième durée, différente de la première durée.

**10.** Procédé selon la revendication 8 ou 9, le premier étalon et le deuxième étalon ayant été exposés au deuxième gaz lors de l'étape b) respectivement, pendant une première durée et pendant deuxième durée, la première durée ayant été choisie en fonction d'au moins une première valeur prédéterminée de bruit de fond diffus ou d'au moins une première gamme prédéterminée de valeurs de bruit de fond diffus que le premier étalon est destiné à mesurer, la deuxième durée ayant été choisie en fonction d'au moins une deuxième valeur prédéterminée de bruit de fond diffus ou d'au moins une deuxième gamme prédéterminée de valeurs de bruit de fond diffus que le deuxième étalon est destiné à mesurer.

**11.** Procédé d'étalonnage d'un appareil destiné à exploiter et/ou mesurer au moins une valeur de bruit de fond diffus comprenant les étapes consistant à :

- fournir au moins un étalon obtenu à l'aide d'un procédé selon l'une des revendications 2 à 9,
- émettre au moins un rayonnement lumineux en direction des nano-structures dudit étalon,
- mesurer, suite à l'émission, à partir d'au moins un rayon diffracté ou diffusé par l'étalon, au moins une une valeur de bruit de fond diffus.

FIG. 1

FIG. 4

FIG. 2A

FIG. 2B

FIG. 2C

FIG. 2D

FIG. 2E

FIG. 3

FIG. 5A

FIG. 5B

**Office européen des brevets**

**RAPPORT DE RECHERCHE EUROPEENNE**

Numéro de la demande

EP 06 11 7622

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 5 076 691 A (TULLIS ET AL) 31 décembre 1991 (1991-12-31) * figure 3 * * colonne 4, ligne 5 - ligne 19 * * colonne 7, ligne 11 - ligne 20 * | 1 | INV. H01L23/544 C23C16/24 C23C16/44 |
| A | | 2-11 | ADD. G12B21/20 |
| Y | PATENT ABSTRACTS OF JAPAN vol. 012, no. 406 (P-777), 27 octobre 1988 (1988-10-27) -& JP 63 144242 A (DAINIPPON PRINTING CO LTD), 16 juin 1988 (1988-06-16) * abrégé; figures 1,2 * | 1 | |
| A | | 2-11 | |
| A | US 6 784 103 B1 (RAO RAJESH A ET AL) 31 août 2004 (2004-08-31) * figures 1-4 * * colonne 3, ligne 37 - colonne 9, ligne 22 * | 2-9 | |

**DOMAINES TECHNIQUES RECHERCHES (IPC)**

H01L
G01N
C23C

Le présent rapport a été établi pour toutes les revendications

| Lieu de la recherche | Date d'achèvement de la recherche | Examinateur |
|---|---|---|
| Berlin | 12 octobre 2006 | Polesello, Paolo |

**ANNEXE AU RAPPORT DE RECHERCHE EUROPEENNE
RELATIF A LA DEMANDE DE BREVET EUROPEEN NO.**

EP 06 11 7622

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-10-2006

| Document brevet cité au rapport de recherche | | Date de publication | Membre(s) de la famille de brevet(s) | Date de publication |
|---|---|---|---|---|
| US 5076691 | A | 31-12-1991 | AUCUN | |
| JP 63144242 | A | 16-06-1988 | AUCUN | |
| US 6784103 | B1 | 31-08-2004 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5198869 A
- US 5599464 A
- US 6201601 B
- US 6271916 B

**Littérature non-brevet citée dans la description**

- **HOLSTEYNS et al.** Monitoring and qualification using comprehensive surface haze information. *IEEE International Symposium on Semiconductor Manufacturing,* 2003, 378-381